# DEMANDE DE BREVET EUROPEEN

(11) **EP 1 521 365 A2**
(43) Date de publication de la demande: **06.04.2005**
(21) Numéro de dépôt: 04292039.7
(22) Date de dépôt: 11.08.2004
(51) Int. Cl.: H03K 5/13, H03L 7/081

(54) **Dispositif de retard numérique, oscillateur numérique générateur de signal d'horloge, et interface mémoire**

(30) Priorité: 01.10.2003 FR 0311517
(71) Demandeur: Arteris, 75008 Paris (FR)
(72) Inventeur: Monterrus, Luc, 78180 Montigny le Bretonneux (FR); Boucard, Philippe, 78150 Le Chesnay (FR); Lecler, Jean-Jacques, 06800 Cagnes sur Mer (FR)
(74) Mandataire: Casalonga, Axel

(57) **Abrégé**

Dispositif de retard numérique commandé, comprenant une pluralité d'éléments de retard fins et une pluralité d'éléments de retard grossiers, capables de retarder un signal d'horloge généré par ledit dispositif, d'un délai respectivement fin ou grossier, les éléments de retard fins présentant des délais de retard compris entre 60% et 170% de la moyenne des délais fins et la somme des délais fins de retard est supérieure ou égale à au moins un délai grossier.

## Description

La présente invention concerne le domaine des dispositifs de retard numérique, des oscillateurs numériques comportant de tels dispositifs de retard et plus généralement des générateurs de signal d'horloge qui comprennent en général au moins un oscillateur numérique.

On connaît par l'article intitulé « An all-Digital PLL Clock Multiplier » de Messieurs Thomas Olsson et Peter Nilsson, ap-asik 2002, disponible à l'adresse www.ap- asik.org/2002/Proceedings/5B/5B 3.pdf une boucle à verrouillage de phase numérique réalisée en technologie intégrée à partir de cellules standard trouvées dans la plupart des librairies de cellules standard numériques. La boucle à verrouillage de phase a une fréquence dans la plage de 152 à 366 MhZ et comprend une structure bouclée avec un détecteur de phase, un filtre, un oscillateur commandé numériquement et un diviseur de fréquence. Le filtre consiste en un compteur et un filtre numérique récursif. Pour des applications demandant une haute résolution et une faible consommation de l'oscillateur à commande numérique, une conception sur mesure est préférable. Pour des hautes fréquences de fonctionnement, un convertisseur numérique/analogique suivi par un oscillateur à commande en tension peut être une bonne alternative.

Comme cela est connu, les systèmes numériques sur circuits intégrés nécessitent des horloges pour cadencer leur fonctionnement. Les horloges peuvent être générées en externe ou en interne en utilisant des boucles à verrouillage de phase. Les boucles à verrouillage de phase sont numériques ou analogiques et sont de mise au point difficile et relativement onéreuses. En effet, un asservissement en phase est un système du deuxième ordre à l'image de l'asservissement en position en utilisant une erreur qui est une accélération. Il peut donc se produire des instabilités dans certaines conditions de fonctionnement.

Dans des systèmes de communication globalement asynchrones pour lesquels maintenir une cohérence de phase n'est pas indispensable, on peut utiliser une boucle à verrouillage de fréquence dont la conception est plus simple car seule la fréquence est garantie mais pas la phase avec le signal de référence. Un asservissement en fréquence est un système du premier ordre, à l'image de l'asservissement d'une vitesse à partir d'une erreur mesurée sur la vitesse.

En d'autres termes, l'asservissement en phase et l'asservissement en fréquence peuvent être illustrés par un asservissement avec un train en mouvement. L'asservissement en phase revient à choisir le début d'un wagon du train et à essayer de toujours rester à la hauteur du début du wagon choisi. L'asservissement en fréquence est à rapprocher d'un asservissement visant à augmenter sa vitesse ou à la diminuer d'une quantité fixe dès que l'on a un wagon de retard ou d'avance.

Une implémentation possible de boucle à verrouillage de fréquence, ou comparateur de fréquences, met en oeuvre un oscillateur contrôlé numériquement et pourvu de retards programmables, chaque retard étant commandé par un signal numérique. Or, la maîtrise précise des délais de retard est d'autant plus importante que la fréquence est élevée.

La présente invention propose un dispositif de retard numérique apte à fonctionner à des fréquences très élevées allant de quelques centaines de MHz à quelques GHz, tout en restant de coût faible.

Le dispositif de retard numérique commandé, selon un aspect de l'invention, comprend une pluralité d'éléments de retard fins et une pluralité d'éléments de retard grossiers, capables de retarder un signal généré par ledit dispositif, d'un délai respectivement fin ou grossier. Les éléments de retard fins présentent des délais de retard compris entre 60 et 170 % de la moyenne des délais fins et la somme des délais fins de retard est supérieure ou égale à l'un quelconque des délais grossiers. Les délais fins peuvent être théoriquement égaux et en pratique compris entre 86 et 116% compte tenu des dispersions de fabrication. Le dispositif comprend un élément de commande et de gestion (43) des éléments de retard fins et des éléments de retard grossiers, apte à activer et à désactiver lesdits éléments de retard fins et éléments de retard grossiers, en fonction d'une boucle à verrouillage de fréquence.

On peut ainsi maîtriser de façon précise les délais. En effet, si l'on prend deux dispositifs électroniques intégrés dont le dessin des masques de fabrication est rigoureusement identique, on mesurera en sortie de fabrication des délais différents en raison des dispersions des gravures effectuées à partir des masques lors de la fabrication. Dans les systèmes analogiques, on utilise des éléments dont les dimensions sont grandes comparées à la taille des défauts. Dans le cas de cellules numériques, on utilise au contraire des largeurs de gravure proches des limites technologiques. Il en découle des dispersions de délais relativement importantes pouvant atteindre 5 % et qui peuvent présenter une influence, en particulier lorsque l'on désire échanger un délai grossier contre plusieurs délais fin dans un oscillateur numérique.

On peut prévoir que l'oscillateur numérique couvre au moins une octave dans la gamme des fréquences au moyen des éléments de retard et ce dans toutes les conditions de température et de tension possibles et avec une précision suffisante. A titre d'exemple, en technologie 0,13 micron de largeur de gravure, une variation de 10°C peut faire augmenter le délai d'un oscillateur commandé numériquement d'environ 20 ps. Une variation de 6,7 millivolts de la tension d'alimentation a une influence similaire.

L'élément de commande et de gestion est apte à activer et à désactiver les éléments de retard fins et les éléments de retard grossiers, l'activation d'un élément de retard grossier étant effectuée sans modification des éléments de retard fins, et la désactivation d'un élément de retard grossier étant effectuée tout en activant des éléments de retard fins afin d'éviter une modification importante de la somme des retards et donc de la fréquence. On parvient ainsi à conserver une fréquence de sortie d'un oscillateur commandé numériquement très légèrement inférieure à la fréquence de consigne tout en en étant la plus proche possible.

L'activation d'un délai de retard grossier sans modification des retards fins permet d'augmenter nettement le retard lorsque la fréquence devient trop élevée, ce qui diminue fortement le risque de dépasser la fréquence de consigne, risque que l'on souhaite prioritairement réduire. On pourra ensuite activer des éléments de retard fins pour ramener à nouveau la fréquence de sortie au plus près de la fréquence de consigne.

Au contraire, lorsque la fréquence de sortie est trop faible et que l'ensemble des éléments de retard fins sont déjà désactivés, il devient nécessaire de désactiver au moins un élément de retard grossier. Dans ce cas, simultanément à la désactivation d'un élément de retard grossier, on active tout ou partie, mais au moins une partie significative, des éléments de retard fins afin d'éviter une diminution trop brutale des retards susceptible de faire passer la fréquence de sortie au dessus de la fréquence de consigne. En d'autre termes, on réduit progressivement les retards mais on peut les augmenter de façon brutale. Ainsi, on diminue fortement le risque d'obtenir une fréquence de sortie supérieure à la fréquence de consigne qui peut se traduire par des désordres de fonctionnement du circuit. On augmente de façon significative la fiabilité du circuit.

Dans un mode réalisation de l'invention, les éléments de retard fins présentent des délais de retard compris entre 86 et 116 % de la moyenne des délais fins, préférablement entre 90 et 110 %. De même, les éléments de retard grossiers peuvent présenter des délais de retard ayant la même précision relative que les délais fins.

Avantageusement, les éléments de retard grossiers présentent des délais de retard échelonnés entre eux de façon telle que la somme des délais fins de retard est supérieure ou égale à la différence entre deux combinaisons voisines de délais grossiers de retard. On peut ainsi parvenir à un réglage précis de la somme des retards et donc à la correction de fréquence souhaitée.

Avantageusement, l'élément de commande et de gestion comprend un moyen de synchronisation de la commande des éléments de retard fin et des éléments de retard grossier.

Avantageusement, au moins un élément de retard fin comprend un composant actif pourvu d'une capacité, la variation de délai étant due à l'effet Miller. On rappellera ici que l'effet Miller est modélisé par une capacité entre le drain et la grille d'un transistor MOS, généralement considérée comme une capacité parasite et dont l'influence est généralement considérée comme devant être la plus faible possible.

Au contraire, l'invention met à profit l'existence de la capacité Miller d'un composant actif et l'utilise pour générer un retard. On peut ainsi se servir d'une porte standard, par exemple une porte NOR comme capacité, en d'autres termes comme élément de retard. La capacité Miller d'une porte NOR étant faible, on forme ainsi un élément de retard fin. Ledit élément de retard fin peut comprendre des moyens d'activation et de désactivation partielle de ladite capacité. Ledit élément de retard fin peut comprendre une porte à au moins deux entrées. Ladite porte comprendra avantageusement une sortie isolée. Ladite porte peut comprendre une entrée soumise au signal à retarder. Ladite porte peut comprendre une entrée de commande de l'ajustement de retard.

Dans un mode de réalisation de l'invention, ledit élément de retard fin comprend un inverseur.

Dans un mode de réalisation de l'invention, ledit élément de retard fin comprend un transistor, une entrée reliée à une grille dudit transistor et une sortie.

Avantageusement, le dispositif comprend une pluralité d'éléments de retard fins associés. Un élément de retard fin peut comprendre une résistance et une capacité. La résistance peut être fournie par un inverseur. La capacité peut être fournie par la grille d'une porte NOR qui comporte une capacité due à l'effet Miller. En outre, on peut prévoir un moyen de comptage de partie fractionnaire de période d'horloge de références.

L'invention propose également un oscillateur numérique comprenant un dispositif de retard numérique tel que décrit ci-dessus.

L'invention propose également un générateur de signal d'horloge comprenant une boucle à verrouillage de fréquence et un oscillateur numérique pourvu d'un dispositif de retard numérique tel que décrit ci-dessus.

Grâce à l'invention, on dispose d'un oscillateur numérique apte à fonctionner à des fréquences élevées, de façon fiable, et tout en restant d'un coût raisonnable.

L'invention permet aussi de réaliser une interface de mémoire comprenant deux dispositifs de retard dont l'un est rebouclé. Les deux dispositifs peuvent être reliés à une même commande.

La présente invention sera mieux comprise à la lecture de la description détaillée de quelques modes de réalisation pris à titre d'exemples nullement limitatifs et illustrés par les dessins annexés, sur lesquels :
- la figure 1 est une vue schématique d'un oscillateur numérique selon un aspect de l'invention ;
- les figures 2 et 3 sont des vues schématiques de deux types de modules de retard grossiers ;
- la figure 4 est une vue schématique d'un module de retard fin selon un aspect de l'invention ;
- la figure 5 est une vue schématique d'un dispositif de retard numérique selon un aspect de l'invention ;
- la figure 6 est une vue schématique d'une machine d'état utilisée pour la génération des commandes selon un aspect de l'invention ;
- la figure 7 montre les signaux de la machine d'état de la figure 6 ;
- la figure 8 est une vue schématique d'un élément de comptage de fractions de périodes ; et
- la figure 9 est une vue schématique d'une boucle à verrouillage de fréquence selon un aspect de l'invention.

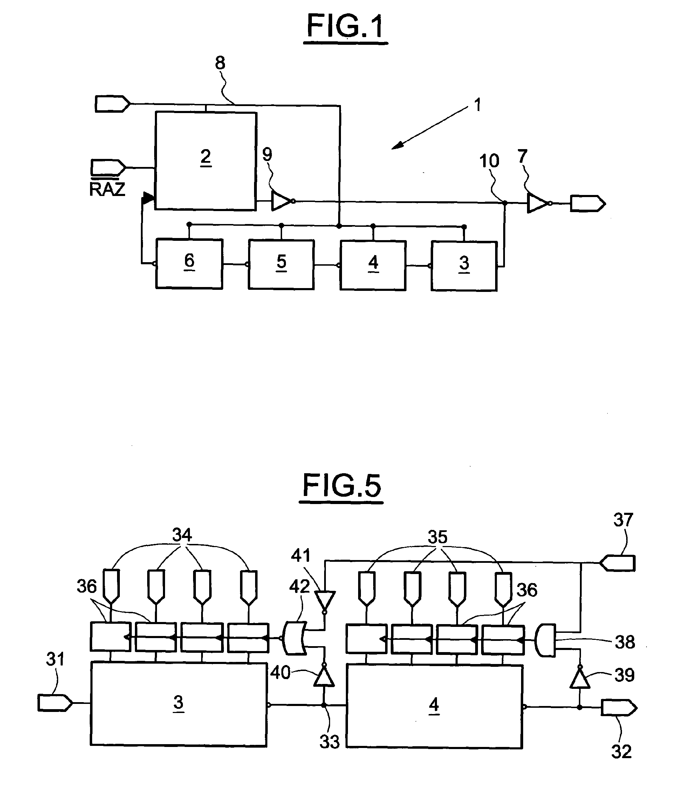

Comme on peut le voir sur la figure 1, le dispositif de retard numérique référencé 1 dans son ensemble comprend un module de retards grossiers 2, quatre modules de retard fins 3, 4, 5 et 6 et un inverseur de sortie 7. Une ligne de commande 8 est reliée au module de retards grossiers 2 et aux modules de retard fins 3 à 6 pour transmettre des ordres de commande. Le module de retards grossiers 2 est en outre relié par une ligne de remise à zéro pour recevoir un ordre de remise à zéro.

La sortie du module de retards grossiers 2 est reliée à un inverseur supplémentaire 9. La sortie de l'inverseur 9 est reliée à un noeud 10 auquel sont également reliées l'entrée de l'inverseur de sortie 7 et l'entrée du module de retard fin 3. Les sorties des modules de retard fins 3, 4, et 5 sont reliées respectivement aux entrées des modules de retard fins 4, 5 et 6. La sortie du module de retard fin 6 est reliée à l'entrée du module de retards grossiers 2. On forme ainsi un oscillateur à commande numérique dont la fréquence est réglable à l'aide du dispositif de retard numérique 1.

De préférence, les retards nominaux des modules de retard fins 3 à 6 sont égaux. Toutefois, compte tenu des inévitables dispersions lors des opérations de fabrication des circuits intégrés, le retard réel d'un module de retard fin n'est connu qu'avec une certaine marge de précision.

La présence de l'inverseur 9 est liée au fait que les modules de retard fins 3 à 6 sont inverseurs et qu'il convient que la boucle d'oscillation contienne un nombre impair d'inverseurs pour osciller. Ainsi, si l'on choisit de réaliser un oscillateur à commande numérique pourvu d'un nombre impair de retards fins, on prévoira une connexion directe de la sortie du module de retards grossiers 2 au noeud 10 en supprimant l'inverseur 9. Au contraire, dans les réalisations comportant un nombre pair de modules de retard fins, la présence de l'inverseur 9 est nécessaire. Le module de retards grossiers 2 est non-inverseur.

Comme on le verra ci-dessous, le module de retards grossiers 2 est capable de générer une pluralité de retards grossiers. Un module de retard fin 3 à 6 est capable de générer de zéro à quatre retards fins. Le fonctionnement de l'oscillateur à commande numérique est le suivant. Lorsque la sortie du module de retards grossiers 2 est à un niveau bas, le noeud 10 est à un niveau haut, ce qui se traduit par un niveau haut en sortie du module de retard fin 6 après la somme des retards fins des modules de retards fins actifs 3 à 6 en fonction de la commande reçue par la ligne de commande 8. Le niveau haut en entrée du module de retards grossiers 2 provoque la mise au niveau haut de la sortie du module de retards grossiers 2 après un retard égal à la somme des retards grossiers actifs au sein dudit module de retards grossiers 2, d'où l'oscillation de l'oscillateur à commande numérique.

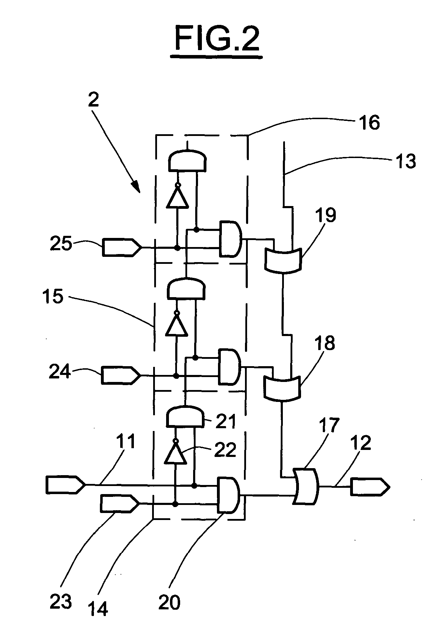

Sur la figure 2 est illustré plus en détail un mode de réalisation du module de retards grossiers 2. Le module de retards grossiers 2 comprend une entrée de signal 11, une sortie de signal 12 et une entrée de commande 13. Le module de retards grossiers 2 comprend une pluralité de sous-modules ou éléments 14 à 16 identiques, ici au nombre de trois, et un nombre égal de portes OU référencées 17 à 19.

Plus précisément, chaque sous-module comprend deux portes ET 20 et 21 et un inverseur 22. La porte ET 20 comprend deux entrées, l'une reliée à l'entrée 11 dans le cas du sous-module 14 et à la sortie de la porte ET 21 du sous-module précédent dans le cas des sous-modules 15 et 16, et l'autre reliée à une entrée de retard respectivement référencées 23, 24 et 25. La porte 21 comprend une entrée reliée à l'entrée de la porte 20 et une autre entrée reliée par l'intermédiaire de l'inverseur 22 à l'autre entrée de la porte 20. La sortie de la porte 20 de chaque module 14 à 16 est reliée respectivement à une entrée de la porte OU 17 à 19. L'autre entrée de la porte OU 17 est reliée à la sortie de la porte OU 18. L'autre entrée de la porte OU 18 est reliée à la sortie de la porte OU 19 et l'autre entrée de la porte OU 19 est reliée à l'entrée de commande 13. La sortie de 1a porte OU 17 forme la sortie 12 du module de retards grossiers.

La sortie de la porte 21 du sous module 16 reste non connectée. La porte 21 du sous module 16 est inactive mais sert à égaliser les charges entre les sous modules de façon que le fonctionnement des sous modules soit le plus homogène possible. Si l'entrée 23 est à un niveau haut, le signal passe par la porte 20 du sous module 14 et la porte 17. Si l'entrée 24 est à un niveau haut et si l'entrée 23 est à un niveau bas, le signal passe par la porte 21 du sous module 14, la porte 20 du sous module 15 et les portes 17 et 18. Le signal est donc retardé par une porte ET et par une porte OU supplémentaires, d'où un retard important, dit grossier. La porte 20 est synchronisée sur la partie basse du signal pour éviter de rajouter des transitions parasites lors d'une modification du signal de commande.

Sur la figure 2, a été représenté un mode de réalisation à trois sous-modules et donc trois retards. Bien entendu, le nombre de sous-modules est adapté à chaque application et peut être relativement élevé. Si l'on souhaite réduire la valeur des retards, on peut remplacer les portes ET par des portes NAND et les portes OU par des portes NOR. En d'autres termes, le module 2 comprend une entrée 23, 24, 25 de commande de retard par retard grossier devant être activé ou désactivé.

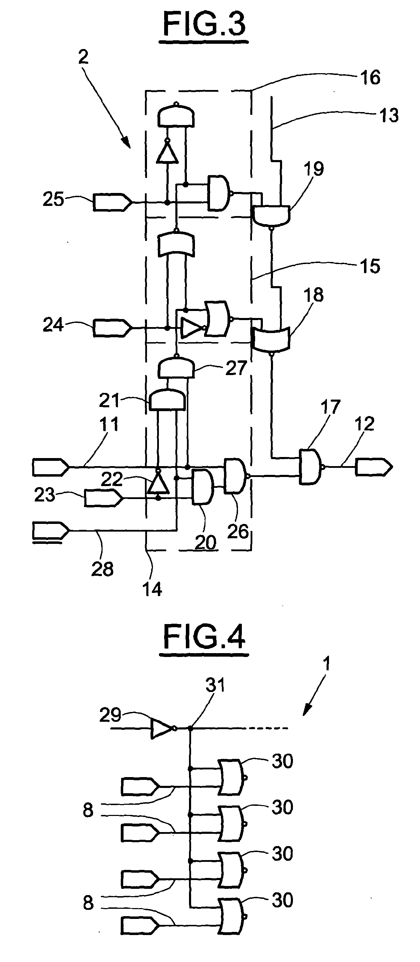

Le mode de réalisation illustré sur la figure 3 se rapproche du précédent à ceci près que le sous-module 14 comprend un moyen de blocage sous la forme de deux portes supplémentaires 26 et 27 et d'une entrée de remise à zéro 28. La sortie de la porte 20 est reliée à une entrée de la porte 26 de type NAND, l'autre entrée de la porte 26 étant reliée au signal d'entrée 11. La sortie de la porte 26 est reliée à l'entrée de la porte 17 qui est ici de type NAND. L'entrée de la porte 20 est reliée au signal de retard 23 et l'autre entrée de la porte 20 est reliée au signal de remise à zéro 28. L'entrée de la porte 21 est également reliée au signal de remise à zéro 28 tandis que l'autre entrée de la porte 21 est reliée à la sortie de l'inverseur 22. Les entrées de la porte 27 de type NAND sont reliées d'une part au signal d'entrée 11, d'autre part, à la sortie de la porte 21. Dans le sous-module 15, les portes 20 et 21 sont de type NOR et dans le sous-module 16, les portes 20 et 21 sont de type NAND. La porte 17 est de type NAND, de même que la porte 19 tandis que la porte 18 est de type NOR. On peut ainsi régler les retards grossiers tout en utilisant des portes pré-caractérisées disponibles dans des librairies standard.

Sur la figure 4, est illustré un mode de réalisation d'un module de délais fins. Chaque module de délais fins est constitué par un inverseur 29 et quatre portes NOR référencées 30 dont la sortie est laissée flottante, non connectée à d'autres éléments. Les portes 30 comprennent chacune une entrée reliée à un noeud 31 commun avec la sortie de l'inverseur 29 et la sortie du module et une autre entrée reliée à une ligne de commande référencée 8. L'entrée de l'inverseur 29 forme l'entrée du module de délais fins. Tant que le signal de commande sur la ligne de commande 8 est à un niveau haut, la sortie de la porte concernée 30 reste à un niveau bas et le signal est peu retardé. En outre, les retards fins peuvent être ajustés en jouant sur la force de l'inverseur.

Au contraire, lorsque le signal sur la ligne de commande 8 est à un niveau bas, le niveau de la sortie est inversé par rapport à celui de l'entrée recevant le signal à retarder et la capacité Miller existant entre ladite entrée et la sortie de la porte 30 voit une tension plus élevée d'où un retard plus fort du signal au noeud 31. En effet, l'entrée d'une telle porte est généralement formée par une grille de transistor MOS et la sortie formée par un drain. En d'autres termes, on ajoute sur une ligne de signal une petite capacité existant dans une porte logique pour créer un délai fin. On met ainsi à profit un défaut des portes logiques, généralement gênant.

Bien entendu, la substitution d'un délai grossier par plusieurs délais fins peut poser quelques difficultés. Une simulation électrique peut donner un nombre de délais fins équivalent à un délai grossier sous certaines conditions de température, de tension, de fabrication, etc., mais qui ne va pas forcément correspondre à la réalité physique, d'où une incertitude de l'ordre de 5%. Il faut tenir compte des variations d'une cellule à l'autre de l'ordre de 5 %. En outre, il faut tenir compte du fait qu'entre une simulation et la réalité peut exister un écart également de l'ordre de 5 %. On aboutit donc à trois sources d'incertitude de 5 % à combiner ensemble soit légèrement plus de 15 %. Toutefois, certaines certitudes peuvent être corrélées entre elles. Une incertitude de 10% pourrait donc être retenue. Bien entendu, une condition nécessaire de fonctionnement est que la somme de tous les délais fins soit strictement supérieure aux délais grossiers.

On remarquera également qu'une erreur par excès ou par défaut sur le délai de l'oscillateur à commande numérique n'a pas les mêmes conséquences. Une erreur par défaut sur le délai peut entraîner une fréquence générée plus élevée que la fréquence limite que peut supporter le circuit monté en aval. A l'inverse, si le délai est trop grand, on perd des cycles de fonctionnement mais il n'y a pas de risque particulier de mise en panne du circuit. Il convient donc de faire en sorte de privilégier l'erreur par excès sur les délais au détriment de l'erreur par défaut, lors des échanges entre des délais fins et un délai grossier et en prenant une marge de sécurité pour couvrir les incertitudes.

Par exemple, si on doit augmenter le délai et que tous les délais fins sont utilisés, on va rajouter un délai grossier et maintenir le nombre de délais fins ou enlever un nombre de délais fins égal au délai grossier diminué de la plage d'incertitude. Dans le cas où on ne peut plus retirer de délais fins et où on doit diminuer le délai, on va retirer un délai grossier et rajouter un nombre de délais fins au moins égal au délai grossier majoré de la plage d'incertitude. Si la précision sur les délais est difficile à contrôler, il est possible de passer de zéro délai fin au nombre maximum de délais fins et de retirer un délai grossier puis d'attendre que la régulation retire à nouveau un certain nombre de délais fins. Il est souhaitable que le nombre de délais fins soit suffisant pour qu'un changement de délai grossier ramène le nombre de délais fins proche du nombre moyen de délais fins disponibles. On limite ainsi les excursions au-delà de la fréquence de consigne et on garantit une meilleure sécurité face aux incertitudes de modélisation. On peut ainsi positionner avec un risque réduit la fréquence de consigne plus près de la fréquence limite de fonctionnement du circuit.

D'éventuelles erreurs sont ensuite rattrapées par l'asservissement de la commande de l'oscillateur à commande numérique, le nombre de cycles perdus reste extrêmement faible par rapport au nombre total de cycles et l'impact sur la performance du circuit est acceptable. Le nombre de cycles perdus va dépendre du type de perturbation et du nombre de délais fins disponibles. Toutefois, le nombre de délais fins résulte du meilleur compromis que l'on peut faire car une augmentation du nombre de délais fins diminue la fréquence maximale de l'oscillateur à commande numérique.

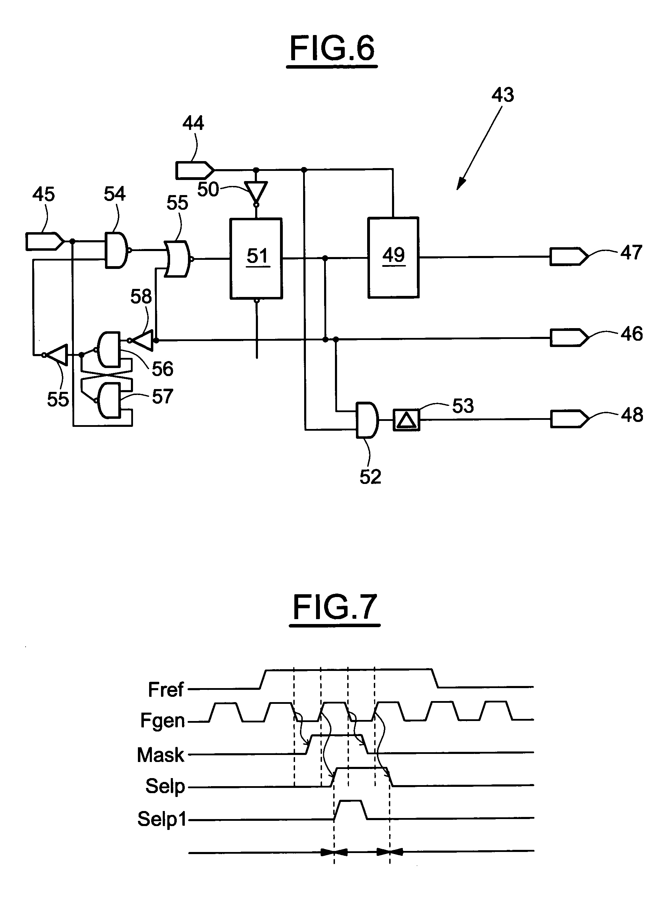

Par ailleurs, lors de la substitution d'un délai grossier par plusieurs délais fins et réciproquement, il convient d'éviter de supprimer l'un des délais avant d'avoir ajouté les autres. A cette fin, il convient soit de synchroniser les commandes de l'oscillateur à commande numérique avec le passage du front d'horloge, soit de d'abord positionner les délais à rajouter avant de positionner les commandes des délais à supprimer. En cas de resynchronisation, on peut prévoir une resynchronisation pour chaque élément de l'oscillateur à commande numérique, voir figure 5.

Le dispositif de retard numérique illustré sur la figure 5 comprend deux modules de retards fins 3 et 4 rebouclés pour osciller comme illustré sur la figure 1, dont l'un comprend une entrée de signal 31 et l'autre une sortie de signal 32, la sortie de l'un étant reliée à l'entrée de l'autre au noeud 33. Chaque module 3, 4 comprend des entrées de commande de retard 34 et 35, ici au nombre de 4 pour chaque module 3, 4. Entre chaque entrée 34, 35 et le module 3, 4 correspondant, est prévue une bascule 36 permettant de mémoriser la commande correspondante. La bascule 36 peut être remplacée par un registre.

Les bascules 36 sont ouvertes après le passage du front montant du signal d'horloge pour le module 3 et descendant pour le module 4. L'oscillateur comprend une entrée 37 de masque d'horloge MASK, une porte ET 38 et un inverseur 39. Le masque d'horloge MASK est un signal dérivé de l'horloge de référence FREF, voir figure 6 infra. La sortie de la porte ET 38 est reliée à l'entrée de synchronisation des bascules 36 des entrées 35. La porte ET 38 possède une entrée reliée à la sortie de l'inverseur 39 dont l'entrée est elle-même reliée à la sortie 32 de l'oscillateur, et une entrée reliée à l'entrée 37.

Il est en outre prévu un inverseur 40 dont l'entrée est reliée au noeud 33 et un inverseur 41 dont l'entrée est reliée à l'entrée de masque d'horloge 37. Les sorties des inverseurs 40 et 41 sont reliées aux entrées d'une porte NOR 42 dont la sortie est reliée à l'entrée de synchronisation des bascules 36 des entrées 34. Ainsi, ce type de montage avec des bascules dont les entrées de synchronisation sont reliées au signal de sortie d'un dispositif de retard programmable et au signal de masque d'horloge permet la synchronisation des entrées du même dispositif de retard programmable.

Sur la figure 6 est illustré un mode de réalisation d'un système de séquencement de contrôle et de commande de boucle à verrouillage de fréquence. Le système de commande et de contrôle référencé 43 dans son ensemble permet de compter un nombre donné de cycles de l'oscillateur à commande numérique dans chaque période de référence. On commence par échantillonner l'horloge de référence FREF par la fréquence générée FGEN. Les erreurs d'échantillonnage de la fréquence de référence sont naturellement compensées aux cycles de ladite fréquence de référence suivant si nécessaire. On repère le premier cycle de la fréquence générée FGEN après le front descendant de l'horloge de référence FREF puis on génère les signaux notamment de masques d'horloge qui vont servir à changer les commandes de l'oscillateur à commande numérique et à initialiser les compteurs de contrôle de boucle. Sur le premier front montant de la fréquence générée FGEN, on vérifie le décompte des cycles restants qui peut être nul, positif ou négatif et on recharge le compteur.

A cet effet, le système de contrôle et de commande 43 comprend une entrée 44 recevant la fréquence générée FGEN, une entrée 45 recevant l'horloge de référence FREF, une sortie 46 fournissant le signal de masque d'horloge MASK, et des sorties 47 et 48 fournissant respectivement un signal dit Selp et Selpl, voir également figure 7. La fréquence générée FGEN reçue sur l'entrée 44 est envoyée d'une part à titre de signal de synchronisation sur une bascule 49 avec remise à zéro asynchrone et d'autre part après avoir été inversée par un inverseur 50 sur l'entrée de synchronisation d'un registre 51. La sortie de la bascule 49 est reliée à la sortie 47 fournissant le signal Selp. La sortie du registre 51 est reliée à l'entrée de la bascule 49 et à la sortie 46 fournissant le signal de masque d'horloge. La fréquence générée FGEN est également envoyée sur l'entrée d'une porte ET 52 dont l'autre entrée est reliée à la sortie du registre 51. La sortie de la porte ET 52 est reliée par l'intermédiaire du module de retard 53 à la sortie 48 fournissant le signal Selp1. Le module de retard 53 peut être réalisé à partir de portes logiques fournissant un retard à la propagation du signal.

L'horloge de référence FREF est envoyée sur une entrée d'une porte NAND 54 dont la sortie est reliée à l'entrée d'une porte NOR 55 dont la sortie est elle-même reliée à l'entrée du registre 51. L'autre entrée de la porte NOR 55 est reliée à la sortie du registre 51. L'autre entrée de la porte NAND 54 est reliée à la sortie d'un inverseur 55 dont l'entrée est reliée à une sortie d'un montage de deux portes NAND 56 et 57 montées en bascule RS, c'est à dire en bascule à commandes SET et RESET avec des entrées de portes logiques croisées. Ainsi, la porte NAND 56 comprend une entrée reliée par l'intermédiaire d'un inverseur 58 à la sortie du registre 51 et une autre entrée reliée à la sortie de la porte NAND 57. La sortie de la porte NAND 56 est reliée d'une part à l'entrée de l'inverseur 55 et d'autre part à une entrée de la porte NAND 57. L'autre entrée de la porte NAND 57 est reliée à l'horloge de référence FREF tandis que la sortie de la porte NAND 57 est reliée à une entrée de la porte NAND 56.En d'autres termes, la bascule RS comprend une entrée reliée à l'entrée 45 et une entrée reliée à la sortie de l'inverseur 58.

Si le résultat du décompte des cycles restants est positif, il convient d'accélérer l'oscillateur à commande numérique en enlevant un délai fin. S'il n'y a plus de délai fin à enlever, il convient alors d'enlever un délai grossier et de rajouter l'équivalent en délais fins auquel on ajoute une marge de sécurité. Si le résultat est négatif, on réduit la vitesse de l'oscillateur de commande numérique en ajoutant un délai fin. S'il n'y a plus de délai fin disponible, on ajoute un délai grossier et on retire les délais fins équivalents moins une certaine marge de sécurité. Enfin, si le résultat est nul, aucune action n'est entreprise sur la commande de l'oscillateur à commande de numérique.

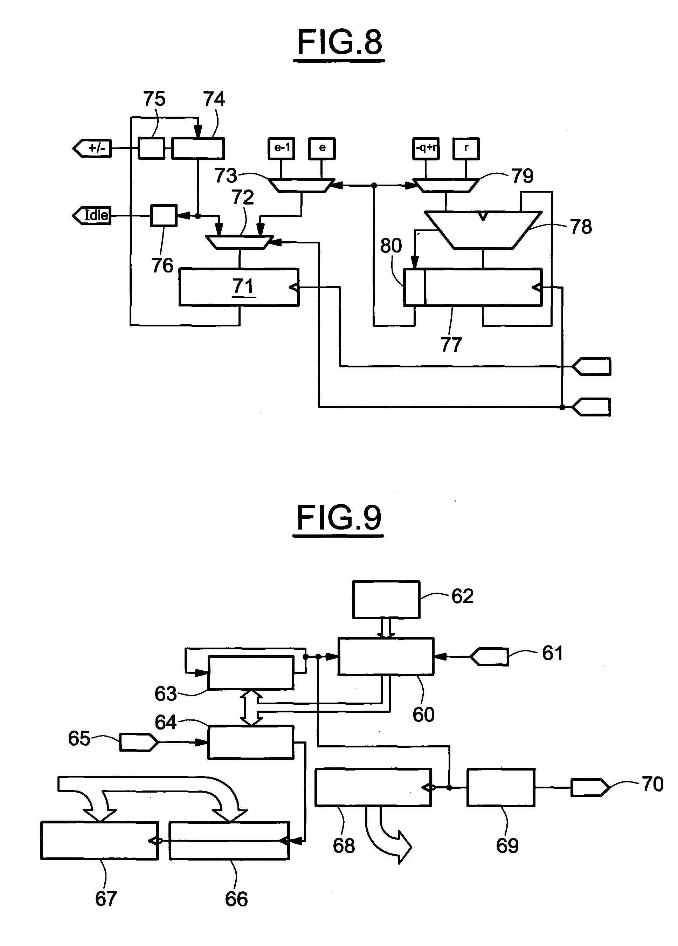

Si on veut afficher une consigne avec une précision plus fine qu'un nombre entier de périodes de référence, il faut pouvoir charger la consigne ou la consigne incrémentée de 1 en fonction de la partie fractionnaire de la consigne, voir figure 8.

L'élément de comptage de fractions de périodes reçoit l'horloge générée FGEN et le signal Selp, et comprend un registre de comptage de cycles 71, un multiplexeur 72 disposé en amont du registre de comptage de cycles 71, un multiplexeur 73 disposé en amont du multiplexeur 72, un élément de décrémentation 74 disposé en sortie du registre de comptage de cycles 71, un élément d'extraction de signe 75 disposé en sortie de l'élément de décrémentation 74, et un comparateur à zéro 76 disposé en sortie de l'élément de décrémentation 74. La sortie de l'élément de décrémentation 74 est également reliée à l'entrée du multiplexeur 72. La sortie du comparateur à zéro 76 fournit un signal "Idle" indiquant à une commande de délais qu'aucune action n'est nécessaire. La sortie de l'élément d'extraction de signe 75 fournit un signal "+/-" correspondant au signe de la valeur de sortie de l'élément de décrémentation 74 et indiquant à une commande de délais qu'il convient d'augmenter ou de diminuer les délais.

L'élément de comptage de fractions de périodes comprend, en outre, un registre de fractions 77 recevant le signal Selp, un additionneur 78 dont la sortie est reliée à l'entrée du registre de fractions 77, et un multiplexeur 79 dont la sortie est reliée à l'entrée de l'additionneur 78. L'autre entrée de l'additionneur 78 est reliée à la sortie du registre de fractions 77. Le registre de fractions 77 comprend, en outre, un indicateur de dépassement 80 dont la sortie permet de cadencer les multiplexeurs 79 et 73. Le multiplexeur 73 reçoit en entrée les valeurs e et (e-1). Le multiplexeur 79 reçoit en entrée les valeurs (-q+r) et r, la fréquence générée FGEN étant égale à (e+r/q) FREF.

Ainsi, l'additionneur 78 ajoute par défaut la valeur r au registre de fractions 77. En cas de dépassement, l'additionneur 78 ajoute la valeur (-q+r) au registre de fractions 77, avec q>r, et le multiplexeur 73 envoie en sortie la valeur e au lieu de la valeur (e-1) par défaut. Au cycle suivant du signal Selp, le multiplexeur 72 envoie en sortie la valeur e au registre de comptage de cycles 71 qui est progressivement décrémenté par l'élément de décrémentation 74. On peut ainsi choisir la fréquence générée avec une grande liberté par rapport à la fréquence de référence et utiliser une fréquence de référence élevée ce qui est favorable en terme de filtrage de bruit.

On peut choisir la partie fractionnaire proportionnelle à 2⁻ⁿ. Si r/q est la partie fractionnaire avec r et q entiers alors on compte par r modulo q à chaque cycle de référence. Les signaux +/- et Idle sont mémorisés pour toute la durée du cycle sur l'horloge FREF et vont permettre l'affichage des nouvelles commandes de délais qui ont été calculées pendant le cycle précédent en y incluant les éventuels échanges de délais fins contre délai grossier. On a donc ici une méthode qui permet d'avoir une bonne précision sur la consigne (FREF/q) tout en gardant une fréquence de référence élevée.

Sur la figure 9, est illustrée une architecture d'interface de mémoire de type SDRAM. En effet, les interfaces de mémoire SDRAM à double débit de données dites DDR émettent des données vers la mémoire avec un décalage d'un quart de période par rapport à chaque front de l'horloge d'émission des données. A la réception des données, une horloge déphasée est redonnée avec les données, les données étant cette fois synchrones sur les fronts d'horloge. Il est donc relativement difficile de retrouver le signal qui sert à échantillonner les données à la réception. La boucle à verrouillage de fréquence telle que décrite ci-dessus permet de générer l'horloge d'émission et l'horloge de réception, car, en utilisant deux modules de délais à commande numérique identiques dont l'un est rebouclé, avec les mêmes commandes on peut générer les mêmes délais de façon relativement aisée.

A cet effet, il est prévu un module de contrôle et de commande de boucle 60 recevant sur une entrée 61 une horloge de référence FREF et recevant également une consigne en provenance, par exemple, d'un bus 62. Les commandes issues du module 60 sont envoyées à deux générateurs de délais 63 et 64 qui peuvent être identiques. Le générateur 63 est rebouclé sur lui-même et sa sortie est en outre envoyée en entrée du module de contrôle et de commande de boucle 60. Le générateur de délai 64 reçoit sur une entrée 65 une horloge de données d'entrée. Le générateur de délai 64 peut être équipé d'un moyen pour synchroniser la commande reçue en provenance du module 60. La sortie du générateur de délai 64 est relié aux entrées de synchronisation de registres d'entrée de données 66 et 67 d'une mémoire SDRAM. Un registre de sortie de données 68 de la même mémoire SDRAM reçoit sur son entrée de synchronisation le signal de sortie du générateur de délai 63. Le signal de sortie du générateur de délai 63 est également envoyé en entrée d'un diviseur par deux 69 dont la sortie 70 fournit un signal d'horloge de sortie dont la fréquence est égale à la moitié de la fréquence de la consigne 62. Comme le signal fait deux passages dans le générateur de délai pour une période d'horloge et que la fréquence de fonctionnement du générateur de délai est le double de la fréquence de l'horloge d'entrée, le délai du générateur de délai est égal au quart de la période de l'horloge d'entrée. Ce retard est précisément celui qui doit être appliqué à l'horloge d'entrée pour avoir le meilleur signal d'échantillonnage des données.

Grâce à l'invention, on bénéficie d'un oscillateur numérique particulièrement performant tout en restant économique en étant réalisé à partir de cellules standard. L'invention s'applique à de nombreux types de circuits, notamment intégrés, et en particulier aux mémoires.

L'invention permet également d'utiliser une boucle à verrouillage de fréquence ou comparateur de fréquences.

## Revendications

1. Dispositif de retard numérique commandé (1), **caractérisé par le fait qu'**il comprend une pluralité d'éléments de retard fin (3, 4) et une pluralité d'éléments de retard grossier (14, 15) capables de retarder un signal généré par ledit dispositif, d'un délai respectivement fin ou grossier, les éléments de retard fins présentant des délais de retard compris entre 60% et 170% de la moyenne des délais fins et la somme des délais fins de retard est supérieure ou égale à l'un quelconque des délais grossiers de retard, et qu'il comprend un élément de commande et de gestion (43) des éléments de retard fins et des éléments de retard grossiers, apte à activer et à désactiver lesdits éléments de retard fins et éléments de retard grossiers, en fonction d'une boucle à verrouillage de fréquence.

2. Dispositif selon la revendication 1, **caractérisé par le fait que** les éléments de retard fins présentent des délais de retard compris entre 85% et 116% de la moyenne des délais fins, préférablement entre 90% et 110%.

3. Dispositif selon la revendication 1 ou 2, **caractérisé par le fait que** les éléments de retard grossiers présentent des délais de retard ayant la même précision relative que les délais fins.

4. Dispositif selon la revendication 1 ou 2, **caractérisé par le fait que** les éléments de retard grossiers présentent des délais de retard échelonnés de façon telle que la somme des délais fins de retard est supérieure ou égale à la différence entre deux combinaisons voisines de délais grossiers de retard.

5. Dispositif selon l'une quelconque des revendications 1 à 4, **caractérisé par le fait que** l'élément de commande et de gestion (43) des éléments de retard fins et des éléments de retard grossiers, apte activer et à désactiver lesdits éléments de retard fins et éléments de retard grossiers, l'activation d'un élément de retard grossier étant effectuée sans modification des éléments de retard fins, et la désactivation d'un élément de retard grossier étant effectuée tout en activant des éléments de retard fins afin d'éviter une modification importante de la somme des retards.

6. Dispositif selon l'une quelconque des revendications 1 à 5, **caractérisé par le fait que** l'élément de commande et de gestion (43) comprend un moyen de synchronisation de la commande des éléments de retard fin et des éléments de retard grossier.

7. Dispositif selon l'une quelconque des revendications précédentes, **caractérisé par le fait qu'**au moins un élément de retard fin comprend un composant actif (29) pourvu d'une capacité, la variation de délai étant due à l'effet Miller.

8. Dispositif selon la revendication 7, **caractérisé par le fait que** ledit élément de retard fin comprend des moyens d'activation et de désactivation partielle de ladite capacité.

9. Dispositif selon la revendication 7 ou 8, **caractérisé par le fait que** ledit élément de retard fin comprend une porte à au moins deux entrées.

10. Dispositif selon la revendication 9, **caractérisé par le fait que** la porte comprend une sortie isolée.

11. Dispositif selon la revendication 9 ou 10, **caractérisé par le fait que** la porte comprend une entrée de commande de l'ajustement de retard.

12. Dispositif selon l'une quelconque des revendications 7 à 11, **caractérisé par le fait que** ledit élément de retard fin comprend un inverseur.

13. Dispositif selon l'une quelconque des revendications 7 à 12, **caractérisé par le fait qu'**il comprend une pluralité d'éléments de retard fin associés.

14. Dispositif selon l'une quelconque des revendications précédentes, **caractérisé par le fait qu'**il comprend un moyen pour compter une partie fractionnaire de période d'horloge de référence.

15. Oscillateur numérique comprenant un dispositif selon l'une quelconque des revendications précédentes.

16. Générateur de signal d'horloge comprenant une boucle à verrouillage de fréquence et un oscillateur selon la revendication 15.

17. Interface de mémoire comprenant deux dispositifs selon l'une quelconque des revendications 1 à 14, l'un desdits dispositifs étant rebouclé.

18. Interface selon la revendication 17, **caractérisée par le fait que** les deux dispositifs sont reliés à une même commande.
